(19) Europäisches Patentamt
European Patent Office
Office européen des brevets

(11) EP 2 698 987 A1

(12) EUROPEAN PATENT APPLICATION

(43) Date of publication:
19.02.2014 Bulletin 2014/08

(51) Int Cl.:
H04N 5/357 (2011.01)  H04N 5/363 (2011.01)

(21) Application number: 13172218.3

(22) Date of filing: 17.06.2013

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME

(30) Priority: 14.08.2012 US 201213584877

(71) Applicants:
• Luxen Technologies, Inc.
Seoul 121-835 (KR)

• Soh, Myung-Jin
Langley, British Columbia V2Y 0B2 (CA)

(72) Inventors:
• Soh, Myung-Jin
Langley, British Columbia V2Y0B2 (CA)
• Soh, Seul-Yi
Langley, British Columbia V2Y0B2 (CA)

(74) Representative: Patentanwälte Freischem
Salierring 47-53
50677 Köln (DE)

(54) Noise-resistant sampling circuit and image sensor

(57) An approach for a sampling circuit to reduce noise in signals (e.g., as received from photo diodes or the like) is provided. In one embodiment of the present invention, there is a sampling circuit comprising: an amplifier, which amplifies charge signals generated at photo diodes and converts them to voltage signals; the first sample and hold circuit, which samples the voltage signal and charges the first capacitor according to the first switching signal, and outputs the stored charge as a reset signal based on a readout signal; the second sample and hold circuit, which samples the signals and charges the second capacitor according to the second switching signal that is non-overlapping to the first switching signal, and outputs the stored charge as a reset signal based on the readout signal; a resistor that acts as a low-pass filter placed in between the first and the second capacitors' common nodes.

FIG. 1

EP 2 698 987 A1

## Description

FIELD OF THE INVENTION

In general, embodiments of the present invention relate to a sampling circuit. Specifically embodiments, of the present invention relate to a noise-resistant/reducing sampling circuit that amplifies charges created at photodiodes and coverts the amplified signals to voltage signals.

BACKGROUND OF THE INVENTION

Conventional image sensors adopt a two-dimensional arrayed structure of multiple pixels with photo diodes (photo sensor) attached on top of the pixel array. An amplifier from each pixel may receive charge signals generated at the photo diodes and convert the received charge signals into voltage signals. A correlated double sampling (CDS) circuit may extract image signals by comparing the voltage signals to a reset voltage. Extracted image signals may then be read out row by row.

These delicate image signals may be vulnerable to even a smallest amount of noise, necessitating reduction or elimination of noise factors (e.g., experienced during sampling and/or from external sources). Though the CDS circuit may function as a noise filter at low frequencies, it is crucial to filter out noises at higher frequencies in order to prevent any undesirable effects on final images after processing due to errors in sampling signals.

Heretofore, attempts have been made in providing image-based integrated circuits.

U.S. Patent Number 5,554,944 discloses a sampling circuit including a first main terminal, a series coupling of a hold capacitor, a sampling switch between the first main terminal and a second main terminal, a parallel circuit of a coil, and a resistor coupled in series with the sampling switch and the hold capacitor, whereby the combination of the coil, the resistor, and the hold capacitor generate an excitation within a time period in which the sampling switch is conductive.

U.S. Patent Number 7,924,062 discloses a sampling circuit which includes an amplifier, a sampling capacitor, a feedback capacitor, and a voltage source. The sampling capacitor and the feedback capacitor are coupled to the same input terminal of the amplifier, such that the offset of the amplifier and low-frequency noise can be cancelled.

U.S. Patent Number 8,035,421 discloses a charge sampling circuit and has a control signal generator for controlling an analog input signal to the charge sampling circuit to be integrated by an integrator during a sampling phase responsive to a sampling signal from the control signal generator.

U.S. Patent Number 8,143,922 discloses a sampling circuit for sequential sampling of a broadband periodic input signal having a field effect transistor as a nonlinear component to which a pulsed-shaped sampling signal is supplied, by which sampling is activated so that an output signal is produced.

U.S. Patent Number 8,179,165 discloses a sampling circuit including a number of state elements or flip-flops. The state elements or flip-flops are each clocked by a signal that causes them to sample their inputs at a predetermined time. In sampling a plurality of digital inputs, a captured delay chain value is stored by the sampling circuit.

Unfortunately, none of these attempts address the issues of the related art.

SUMMARY OF THE INVENTION

In general, embodiments of the present invention provide an approach for a sampling circuit to reduce noise in signals (e.g., as received from photo diodes or the like). In a typical embodiment, the sampling circuit comprises: an amplifier, which amplifies charge signals generated at a set (one or more) of photo diodes and converts the charge signals to voltage signals; a first sample and hold circuit that samples the voltage signal and charges a first capacitor according to a first switching signal and outputs the stored charge as a reset signal based on a readout signal; a second sample and hold circuit that samples the signals and charges a second capacitor according to a second switching signal that is non-overlapping to the first switching signal and outputs the stored charge as a reset signal based on the readout signal; and/or a resistor that acts as a low-pass filter placed in between common nodes of the first and the second capacitors.

A first aspect of the present invention provides a noise-reducing circuit, comprising: a low pass filter receiving voltage signals from a pixel sensor; a first sample and hold circuit coupled to the low pass filter, the first sample and hold circuit comprising a first set of switches coupled to a first buffer; and a second sample and hold circuit coupled to the low pass filter, the second sample and hold circuit comprising a second set of switches coupled to a second buffer, and the first sample and hold circuit and the second sample and hold circuit being configured to receive a filtered signal from the low pass filter and to output a set of processed signals.

A second aspect of the present invention provides a noise reducing circuit, comprising: an amplifier configured to amplify a charge signal received from a set of photo diodes and to convert the charge signal to a voltage signal; a first sample and hold circuit coupled to the amplifier, the first sample and hold circuit being configured to sample and store the voltage signal, to charge a first capacitor according to a first switching signal, and to output the stored signal as a first reset signal; and a second sample and hold circuit coupled to the amplifier, the second sample and hold circuit being configured to sample and store the voltage signal, to charge a second capacitor according to a second switching signal, and to output the stored signal as a second reset signal.

A third aspect of the present invention provides a method for reducing noise in a signal, comprising: amplifying a charge signal received from a photo diode with an amplifier to yield a voltage signal; passing the voltage signal from the amplifier through a low pass filter to reduce a noise level in the voltage signal; sampling and storing the voltage signal in a first sample and hold circuit; sampling and storing the voltage signal in a second sample and hold circuit; outputting the stored voltage signal from the first sample and hold circuit as a first reset signal; and outputting the stored voltage signal from the second sample and hold circuit as a second reset signal.

BRIEF DESCRIPTION OF THE DRAWINGS

These and other features of this invention will be more readily understood from the following detailed description of the various aspects of the invention taken in conjunction with the accompanying drawings in which:

Fig. 1 shows a schematic diagram showing a sampling circuit of an image sensor according to an embodiment of the present invention.
Fig. 2 shows a schematic diagram illustrating the operation of the sampling circuit according to an embodiment of the present invention.
Fig. 3 shows a schematic diagram illustrating the operation of the sampling circuit according to an embodiment of the present invention.
Fig. 4 shows resulting output and a control signal of the sampling circuit according to an embodiment of the present invention.
Fig. 5 shows an output signal from a conventional sampling circuit.

The drawings are not necessarily to scale. The drawings are merely schematic representations, not intended to portray specific parameters of the invention. The drawings are intended to depict only typical embodiments of the invention, and therefore should not be considered as limiting the scope of the invention. In the drawings, like numbering represents like elements.

DETAILED DESCRIPTION OF THE INVENTION

Illustrative embodiments will now be described more fully herein with reference to the accompanying drawings, in which exemplary embodiments are shown. This disclosure may, however, be embodied in many different forms and should not be construed as limited to the exemplary embodiments set forth herein. Rather, these exemplary embodiments are provided so that this disclosure will be thorough and complete and will fully convey the scope of this disclosure to those skilled in the art. In the description, details of well-known features and techniques may be omitted to avoid unnecessarily obscuring the presented embodiments.

The terminology used herein is for the purpose of describing particular embodiments only and is not intended to be limiting of this disclosure. As used herein, the singular forms "a", "an", and "the" are intended to include the plural forms as well, unless the context clearly indicates otherwise. Furthermore, the use of the terms "a", "an", etc., do not denote a limitation of quantity, but rather denote the presence of at least one of the referenced items. The word "set" is intended to mean a quantity of at least one. It will be further understood that the terms "comprises" and/or "comprising", or "includes" and/or "including", when used in this specification, specify the presence of stated features, regions, integers, steps, operations, elements, and/or components, but do not preclude the presence or addition of one or more other features, regions, integers, steps, operations, elements, components, and/or groups thereof.

As indicated above, embodiments of the present invention provide an approach for a sampling circuit to reduce noise in signals (e.g., as received from photo diodes or the like). In one embodiment of the present invention, there is a sampling circuit comprising: an amplifier, which amplifies charge signals generated at photo diodes and converts them to voltage signals; the first sample and hold circuit, which samples the voltage signal and charges the first capacitor according to the first switching signal, and outputs the stored charge as a reset signal based on a readout signal; the second sample and hold circuit, which samples the signals and charges the second capacitor according to the second switching signal that is non-overlapping to the first switching signal, and outputs the stored charge as a reset signal based on the readout signal; a resistor that acts as a low-pass filter placed in between the first and the second capacitors' common nodes.

Along these lines, embodiments of the present invention will utilize components such as amplifiers, filters, sampling circuits/samplers, etc. The following section will describe and/or define such components.

As will be further described, a low-pass filter is an electronic filter that passes low-frequency signals but attenuates (e.g., reduces the amplitude of) signals with frequencies higher than the cutoff frequency. The actual amount of attenuation for each frequency varies from filter to filter. It is sometimes called a high-cut filter, or treble cut filter when used in audio applications. A low-pass filter is the opposite of a high-pass filter. A band-pass filter is a combination of a low-pass and a high-pass.

Low-pass filters exist in many different forms, including electronic circuits (such as a hiss filter used in audio), anti-aliasing filters for conditioning signals prior to analog-to-digital conversion, digital filters for smoothing sets of data, acoustic barriers, blurring of images, and so on. The moving average operation used in fields such as finance is a particular kind of low-pass filter, and can be analyzed with the same signal processing techniques as are used for other low-pass filters. Low-pass filters provide a smoother form of a signal, removing the short-term fluctuations, and leaving the longer-term trend.

An optical filter could correctly be called low-pass, but conventionally is described as "long pass" (low frequency is long wavelength), to avoid confusion. An ideal low-pass filter completely eliminates all frequencies above the cutoff frequency while passing those below unchanged. Its frequency response is a rectangular function and is a brick-wall filter. The transition region present in practical filters does not exist in an ideal filter. An ideal low-pass filter can be realized mathematically (theoretically) by multiplying a signal by the rectangular function in the frequency domain or, equivalently, convolution with its impulse response, a sinc function, in the time domain.

However, the ideal filter is impossible to realize without also having signals of infinite extent in time, and so generally needs to be approximated for real ongoing signals, because the sinc function's support region extends to all past and future times. The filter would therefore need to have infinite delay, or knowledge of the infinite future and past, in order to perform the convolution. It is effectively realizable for pre-recorded digital signals by assuming extensions of zero into the past and future, or more typically by making the signal repetitive and using Fourier analysis.

Real filters for real-time applications approximate the ideal filter by truncating and windowing the infinite impulse response to make a finite impulse response. Applying that filter requires delaying the signal for a moderate period of time, allowing the computation to "see" a little bit into the future. This delay is manifested as phase shift. Greater accuracy in approximation requires a longer delay.

An ideal low-pass filter results in ringing artifacts via the Gibbs phenomenon. These can be reduced or worsened by choice of windowing function, and the design and choice of real filters involves understanding and minimizing these artifacts. For example, "simple truncation [of sinc] causes severe ringing artifacts," in signal reconstruction, and to reduce these artifacts one uses window functions "which drop off more smoothly at the edges".
The Whittaker-Shannon interpolation formula describes how to use a perfect low-pass filter to reconstruct a continuous signal from a sampled digital signal. Real digital-to-analog converters use real filter approximations.

One simple electrical circuit that will serve as a low-pass filter consists of a resistor in series with a load, and a capacitor in parallel with the load. The capacitor exhibits reactance and blocks low-frequency signals, causing them to go through the load instead. At higher frequencies, the reactance drops, and the capacitor effectively functions as a short circuit. The combination of resistance and capacitance gives you the time constant of the filter:

$$\tau = RC \text{(represented by the Greek letter tau).}$$

The break frequency, also called the turnover frequency or cutoff frequency (in hertz), is determined by the time constant:

$$f_c = \frac{1}{2\pi\tau} = \frac{1}{2\pi RC}$$

or equivalently (in radians per second):

$$\omega_c = \frac{1}{\tau} = \frac{1}{RC}.$$

One way to understand this circuit is to focus on the time the capacitor takes to charge. It takes time to charge or discharge the capacitor through that resistor: At low frequencies, there is plenty of time for the capacitor to charge up to practically the same voltage as the input voltage.

At high frequencies, the capacitor only has time to charge up a small amount before the input switches direction. The output goes up and down only a small fraction of the amount the input goes up and down. At double the frequency, there's only time for it to charge up half the amount.

Another way to understand this circuit is with the idea of reactance at a particular frequency.

Since DC cannot flow through the capacitor, DC input must "flow out" the path marked $V_{out}$ (analogous to removing the capacitor). Moreover, since AC flows very well through the capacitor (e.g., almost as well as it flows through solid wire), AC input "flows out" through the capacitor, effectively short circuiting to ground (analogous to replacing the capacitor with just a wire). The capacitor is not an "on/off" object (like the block or pass fluidic explanation above). The capacitor will variably act between these two extremes. It is the Bode plot and frequency response that show this variability.

Correlated double sampling (CDS) is a method to measure electrical values such as voltages or currents that allows removing an undesired offset. It is used often when measuring sensor outputs. The output of the sensor is measured twice: once in a known condition and once in an unknown condition. The value measured from the known condition is then subtracted from the unknown condition to generate a value with a known relation to the physical quantity being measured.

This is commonly used in switched capacitor operational amplifiers to effectively double the gain of the charge sharing operational amplifier (op-amp), while adding an extra phase. When used in imagers, correlated double sampling is a noise reduction technique in which the Reference Voltage of the pixel (i.e., the pixel's voltage after it is reset) is removed from the Signal Voltage of the pixel (i.e., the pixel's voltage at the end of integration) at the end of each integration period.

In electronics, a sample and hold (S/H, also "follow-and-hold"[1]) circuit is an analog device that samples (captures, grabs) the voltage of a continuously varying analog signal and holds (locks, freezes) its value at a constant level for a specified minimal period of time. Sample and hold circuits and related peak detectors are the elementary analog memory devices. They are typically used in analog-to-digital converters to eliminate variations in input signal that can corrupt the conversion process.

A typical sample and hold circuit stores electric charge in a capacitor and contains at least one fast FET switch and at least one operational amplifier. To sample the input signal, the switch connects the capacitor to the output of a buffer amplifier. The buffer amplifier charges or discharges the capacitor so that the voltage across the capacitor is practically equal, or proportional to, input voltage.

In hold mode, the switch disconnects the capacitor from the buffer. The capacitor is invariably discharged by its own leakage currents and useful load currents, which makes the circuit inherently volatile, but the loss of voltage (voltage drop) within a specified hold time remains within an acceptable error margin. In the context of LCD screens, it is used to describe when a screen samples the input signal, and the frame is held there without redrawing it. This does not allow the eye to refresh and leads to blurring during motion sequences, also the transition is visible between frames because the backlight is constantly illuminated, adding to blurring.

An analog-to-digital converter (e.g., ADC, A/D or A-to-D) is a device that uses sampling to convert a continuous quantity to a discrete time representation in digital form. The reverse operation is performed by a digital-to-analog converter (DAC). An ADC may also provide an isolated measurement such as an electronic device that converts an input analog voltage or current to a digital number proportional to the magnitude of the voltage or current. However, some non-electronic or only partially electronic devices, such as rotary encoders, can also be considered ADCs. The digital output may use different coding schemes. Typically, the digital output will be a two's complement binary number that is proportional to the input, but there are other possibilities. An encoder, for example, might output a Gray code.

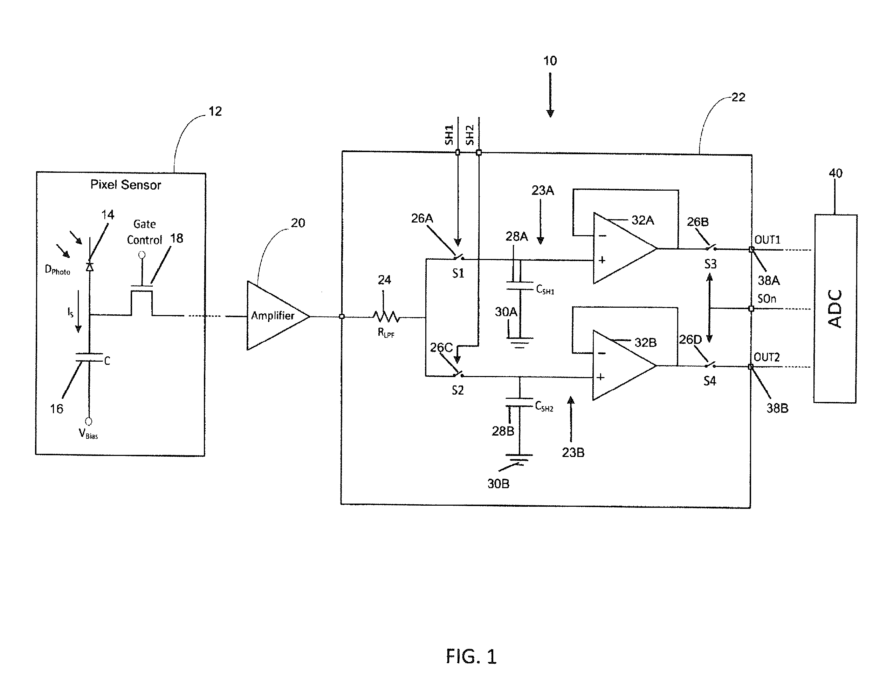

Referring to Fig. 1, a noise-resistant circuit 10 according to an embodiment of the present invention is shown. As depicted, circuit 10 comprises a pixel sensor 12 coupled to an amplifier 20, which itself is coupled to a sampling circuit 22. As further shown, pixel sensor 12 comprises a photo diode 14 (e.g., $D_{photo}$) coupled to a capacitor 16 (charged with a bias voltage ($V_{bias}$)) and a control gate 18 (e.g., controlled by a gate control signal). Sampling circuit 22 comprises a low pass filter 24 (e.g., $R_{LPF}$), a first sample and hold circuit 23A, and a second sample and hold circuit 23B. Sample and hold circuits 23A-B each include similar/complementary components such as switches 26A-D controlled by switching signals SH1 and SH2, sample and hold capacitors 28A-B ($C_{SH1}$, $C_{SH2}$) that are coupled to grounds 30A-B, and unity gain buffers 32A-B for holding/storing signals prior to being output via output nodes 38A-B (OUT1 and OUT2) to ADC 40.

In general, charge signals generated at photo diode 14 are outputted from pixel sensor 12 when photons flow through control gate 18. Amplifier 20 then receives the signals to amplify and converts them into corresponding voltage signals. Sampling circuit 22 receives the voltage signals coming from the amplifier 20 after the signals pass through low-pass filter/resistor 24 to reduce a noise level therein. The first and second switching signals of SH1 and SH2 may have non-overlapping signals so that they can enable switches 26A and 26C one at a time. One node of each of the capacitors 28A-B is connected to the respective switches 26A and 26C, while the other node is grounded.

The sampled and held rest signals then travel through unity-gain buffers 32A-B with high input impedance and low output impedance, which relays the signal in forward direction but not the other way around. Output switches 26B and 26D receive the reset signals and outputs them through two output nodes OUT1 and OUT2 to ADC 38. As further shown, output switches 26B and 26D may be controlled by a common switching signal SOn.

The final output reset signals from above may then be converted into digital form, and the difference between the reset signals and the input signals produces image signals in each pixel. During the process, the resistor 24 and the capacitors 18A-B together form a low pass filter, which prevents any high frequency signals from passing through. The following is an equation for the low pass filter:

$$H^2(\omega) = \frac{1}{1 + \omega^2 \tau^2}$$

$\tau = R_{LPF} \times C_{SH1,2}$ is a time constant that determines the limiting frequency of the filter. Therefore, by adding a series of adequate resistors 24 in between an output node of the amplifier 20 and the sample and hold circuits 23A-B, a similar effect as adding a low pass filter can be achieved. The above low pass filter resistor 24 may be configured as multiple gate-drain connected MOS transistors.

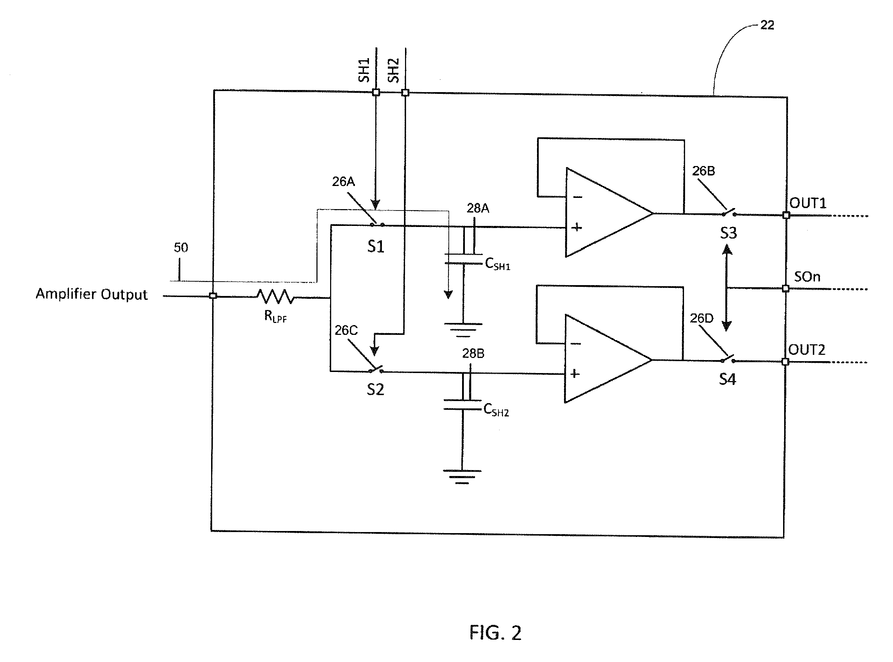

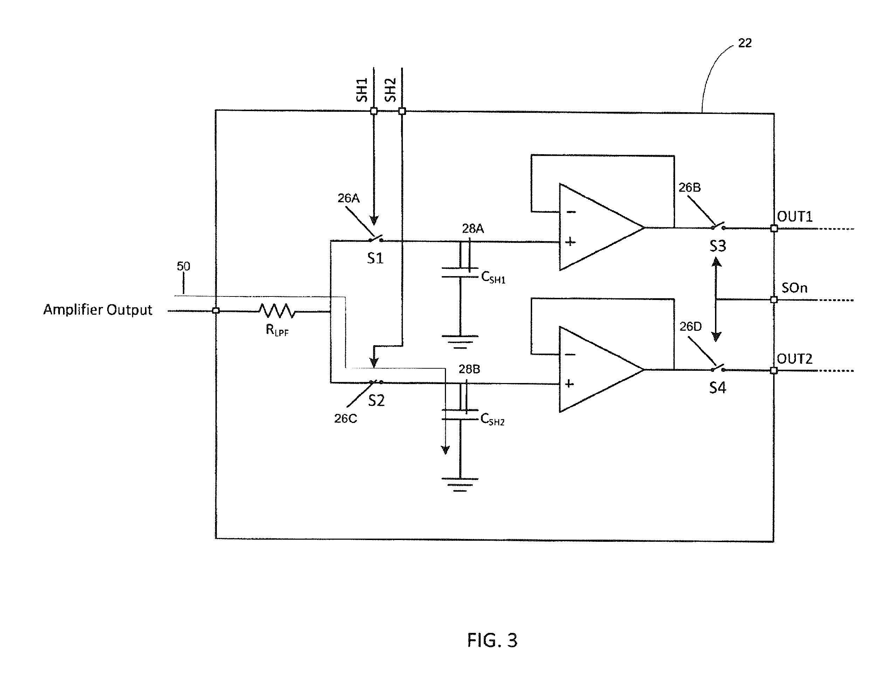

Figs. 2 and 3 show the offset sampling and signal sampling operation and output paths for sampling circuit 22. For example, in Fig. 2, when switch 26A is "ON", switch 26C is "OFF" as are switches 28B and 28D. As shown by flow 50, "offset voltage" of the photo diode may be sampled and stored in capacitor 28A. In Fig. 3, when switch 26C is "ON," switches 26A, 26B, and 26D are "OFF". At that point an "offset + signal" of the photo diode is sampled and stored in capacitor 28B.

Thereafter, switches 26B and 26D may be "ON" at the same time so that "offset voltage" at the node "OUT1" and "offset voltage + signal voltage" at the node "OUT2" may be output simultaneously (e.g., as output signals). This configuration allows for a pure signal voltage without "offset" by the subtraction of "OUT1" from "OUT2" at the next stage ADC 38 (Fig. 1). Along these lines, ADC 38 of Fig. 1 may be a differential type analog to digital converter.

In general, the first sampling is for offset voltage from leakage, or device mismatches, etc., while the second sample is for signal sampling and holding. However, the second sampling may have offset voltage as well. Therefore, the first and second sampled voltages should be output at the same time to perform a "subtraction operation" at ADC 40 (Fig. 1).

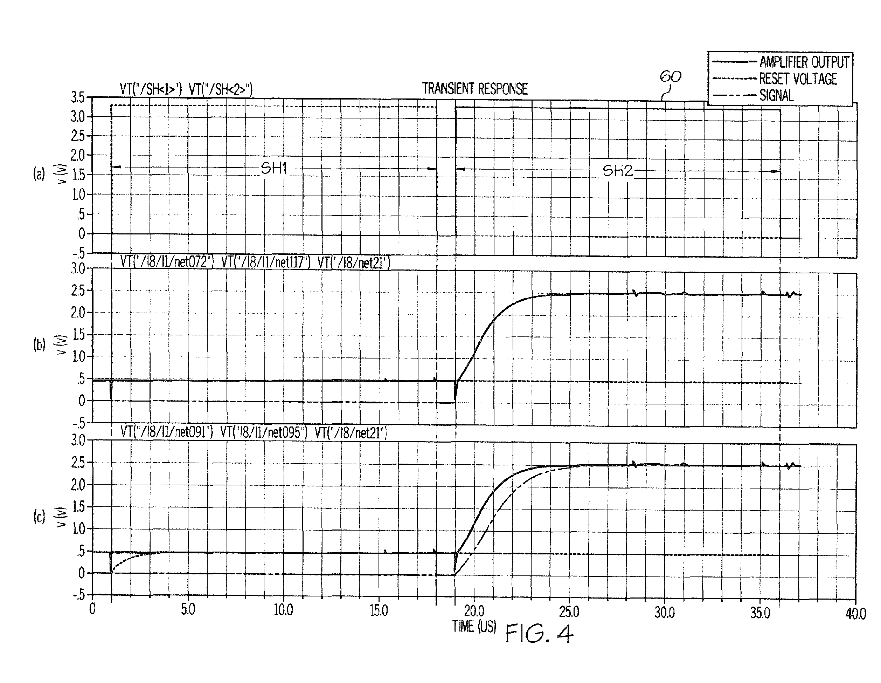

Referring to Fig. 4, a diagram 60 having output and control signals generated by the sampling circuit of the embodiments of the present invention is shown. Specifically, segment (a) represents a sampling period of the reset signal and input voltage signal based on switching signals SH1 and SH2. Segments (b) and (c) represent an output signal with noise from a conventional sampling circuit (segment (b)), and from the present invention (segment (c)), respectively. From a conventional sampling circuit represented in segment (b), the amplifier's output that contains high frequency noise feeds directly into a CDS circuit, and the circuit samples signals with noises during SH1 and SH2 sampling periods, which affects the final image signal.

Segment (c) represents a reset signal and an input voltage signal obtained by the present invention's amplifier output signal. As can be seen, the output signal from the amplifier still containing a high frequency noise factor feeds into the sampling circuit. The low pass resistor ($R_{LPF}$) and sampling capacitors ($C_{SH1}$, $C_{SH2}$) reduce and/or eliminate any high frequency noise from the signals, resulting in a cleaner output signal due to the configuration provided by the embodiments of the present invention.

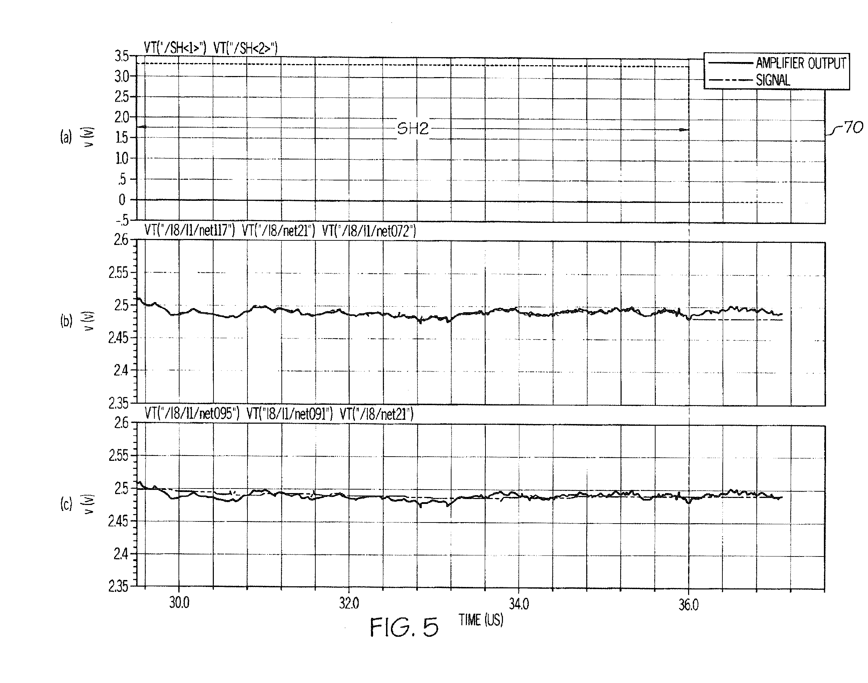

Referring to Fig. 5, a diagram 70 has segment (a) showing a sampling period of the reset signal and input voltage signal based on switching signals SH2. Segment (b) shows that the conventional sampling circuit is extremely susceptible to any high frequency noise, and the noise introduced during the sampling process adversely affects the output signals. Conversely, as shown in segment (c) of Fig. 5, the sampling circuit according to the present invention produces output signals having a greatly reduced noise factor.

The foregoing description of various aspects of the invention has been presented for purposes of illustration and description. It is not intended to be exhaustive or to limit the invention to the precise form disclosed and, obviously, many modifications and variations are possible. Such modifications and variations that may be apparent to a person skilled in the art are intended to be included within the scope of the invention as defined by the accompanying claims.

**Claims**

1. A noise-reducing circuit, comprising:

   a low pass filter receiving voltage signals from a pixel sensor;
   a first sample and hold circuit coupled to the low pass filter, the first sample and hold circuit comprising a first set of switches coupled to a first buffer; and
   a second sample and hold circuit coupled to the low pass filter, the second sample and hold circuit comprising a second set of switches coupled to a second buffer, and the first sample and hold circuit and the second sample and hold circuit being configured to receive a filtered signal from the low pass filter and to output a set of processed signals.

2. The noise-reducing circuit of claim 1, comprising one or more of the following features:

   the voltage signal is received from the pixel sensor via an amplifier;
   the noise-reducing circuit comprises a sampling circuit;
   the first sample and hold circuit further comprises a first sample and hold capacitor, and the second sample and hold circuit further comprises a second sample and hold capacitor; or
   the set of processed signals is received by an analog-to-digital converter.

3. The noise-reducing circuit of claim 1, comprising one or more of the following features:

   the pixel sensor comprises a photo diode coupled to a capacitor and a control gate; or
   the control gate is controlled by a gate control signal.

4. The noise-reducing circuit of claim 1, comprising one or more of the following features:

   the first set of switches comprises a first switch and a second switch, and the second set of switches comprises a third switch and a fourth switch;
   the second switch and the fourth switch comprise an additional low pass filter; or
   the second switch and the fourth switch are controlled by a common signal.

5. A noise reducing circuit, comprising:

   an amplifier configured to amplify a charge signal received from a set of photo diodes and to convert the charge signal to a voltage signal;
   a first sample and hold circuit coupled to the amplifier, the first sample and hold circuit being configured to sample and store the voltage signal, to charge a first capacitor according to a first switching signal, and to output the stored signal as a first reset signal; and
   a second sample and hold circuit coupled to the amplifier, the second sample and hold circuit being configured to sample and store the voltage signal, to charge a second capacitor according to a second switching signal, and to output the stored signal as a second reset signal.

6. The noise reducing circuit of claim 5, further comprising a low-pass filter positioned between the amplifier and the first sample and hold circuit and the second sample and hold circuit.

7. The noise reducing circuit of claim 6, the low-pass filter comprising a resistor.

8. The noise reducing circuit of claim 5, the first sample and hold circuit comprising a first set of switches coupled to a first buffer and the first capacitor, and the second sample and hold circuit comprising a second set of switches coupled to a second buffer and the second capacitor.

9. A method for reducing noise in a signal, comprising:

   amplifying a charge signal received from a photo diode with an amplifier to yield a voltage signal;
   passing the voltage signal from the amplifier through a low pass filter to reduce a noise level in the voltage signal;
   sampling and storing the voltage signal in a first sample and hold circuit;
   sampling and storing the voltage signal in a second sample and hold circuit;

outputting the stored voltage signal from the first sample and hold circuit as a first reset signal; and
outputting the stored voltage signal from the second sample and hold circuit as a second reset signal.

10. The method of claim 9, the first reset signal and the second reset signal being output based on at least one readout signal.

11. The method of claim 9, further comprising:

charging a first capacitor of the first sample and hold circuit according to a first switching signal; and
charging a second capacitor of the second sample and hold circuit according to a second switching signal.

12. The method of claim 9, the low pass filter comprising a resistor.

13. The method of claim 9, the voltage signal being sampled and stored in a first buffer of the first sample and hold circuit.

14. The method of claim 13, the voltage signal being sampled and stored in a second buffer of the second sample and hold circuit.

FIG. 1

FIG. 2

EP 2 698 987 A1

10

FIG. 3

EP 2 698 987 A1

FIG. 4

EP 2 698 987 A1

FIG. 5

Europäisches
Patentamt

European
Patent Office

Office européen
des brevets

## EUROPEAN SEARCH REPORT

Application Number

EP 13 17 2218

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/209803 A1 (YAMAGUCHI AKIRA [JP]) 22 September 2005 (2005-09-22) * the whole document * ----- | 1-14 | INV. H04N5/357 H04N5/363 |
| X | WO 2008/103257 A1 (EASTMAN KODAK CO [US]; XU WEIZE [US]) 28 August 2008 (2008-08-28) * page 1; figure 1 * ----- | 1-14 | |

TECHNICAL FIELDS
SEARCHED     (IPC)

H04N

The present search report has been drawn up for all claims

| Place of search | Date of completion of the search | Examiner |
|---|---|---|
| Berlin | 27 November 2013 | Bernas, Yves |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 13 17 2218

This annex lists the patent family members relating to the patent documents cited in the above-mentioned European search report.
The members are as contained in the European Patent Office EDP file on
The European Patent Office is in no way liable for these particulars which are merely given for the purpose of information.

27-11-2013

| Patent document cited in search report | Publication date | Patent family member(s) | | Publication date |
|---|---|---|---|---|
| US 2005209803 A1 | 22-09-2005 | JP | 4246090 B2 | 02-04-2009 |
| | | JP | 2005269215 A | 29-09-2005 |
| | | US | 2005209803 A1 | 22-09-2005 |
| WO 2008103257 A1 | 28-08-2008 | TW | 200842882 A | 01-11-2008 |
| | | US | 2008204567 A1 | 28-08-2008 |
| | | WO | 2008103257 A1 | 28-08-2008 |

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5554944 A
- US 7924062 B
- US 8035421 B
- US 8143922 B
- US 8179165 B